Europäisches Patentamt

European Patent Office

Office européen des brevets

(19)

(11) Publication number : **0 437 313 B1**

(12) # EUROPEAN PATENT SPECIFICATION

(45) Date of publication of patent specification :
05.07.95 Bulletin 95/27

(51) Int. Cl.[6] : **H05K 9/00**

(21) Application number : **91300038.6**

(22) Date of filing : **03.01.91**

(54) **Shield case structure for an electronic device.**

(30) Priority : **08.01.90 JP 1801/90**

(43) Date of publication of application :
**17.07.91 Bulletin 91/29**

(45) Publication of the grant of the patent :
**05.07.95 Bulletin 95/27**

(84) Designated Contracting States :
**DE FR GB IT NL SE**

(56) References cited :
**DE-A- 2 514 583**
**GB-A- 2 117 989**
**PATENT ABSTRACTS OF JAPAN, vol. 8, no.**
**243 (E-277), 8 November 1984; & JP - A -**
**59122206**

(73) Proprietor : **NEC CORPORATION**
**7-1, Shiba 5-chome**
**Minato-ku**
**Tokyo (JP)**

(72) Inventor : **Toba, Hiroyuki, c/o NEC Corporation**
**7-1, Shiba 5-chome**
**Minato-ku, Tokyo (JP)**

(74) Representative : **Orchard, Oliver John et al**
**JOHN ORCHARD & CO.**
**Staple Inn Buildings North**
**High Holborn**
**London WC1V 7PZ (GB)**

EP 0 437 313 B1

## Description

## BACKGROUND OF THE INVENTION

The present invention relates to an oscillator and, more particularly, to the structure of a shield case for an oscillator which reduces the variation in the oscillation characteristics of the oscillator ascribable to the changes in environmental conditions.

It is a common practice with an oscillator to cover a body thereof with a shield case made of brass, phosphor bronze or similar metal, so that the body may be protected against external electromagnetic fields. Specifically, the metallic shield case shields various parts constituting the circuitry of the oscillator from surrounding electronic devices. To produce such a shield case, a single sheet of metal is bent, pressed, die-casted, cut or otherwise machined. Generally, the so produced shield case has an even wall thickness. Therefore, stray capacitance unavoidably exists between the shield case and various parts constituting the circuitry of the oscillator. When vibration, for example, is applied from the outside to the oscillator, i. e., the shield case having an even wall thickness and if the thickness is small, it causes the shield case to vibrate. The vibration of the shield case changes the physical distance between the inner periphery thereof and the component parts of the circuitry and, therefore, the stray capacitance. As a result, the externally derived vibration adversely affects the oscillation characteristics of the oscillator such as oscillation frequency, preventing the oscillator from oscillating in a stable manner. Should the wall thickness of the shield case be increased to eliminate the above problem, the shield case will become heavy and increase the heat capacity thereof and, therefore, the soldering time, obstructing efficient operations.

Features of arrangements to be described below are a shield case structure which allows an oscillator associated therewith to undergo a minimum of variation in the oscillating state against external vibrations and, therefore, to oscillate more stably, and a generally improved shield case structure for an electronic device.

A shield case structure for an oscillator will be described which is partly increased in wall thickness to reduce, when subjected to externally derived vibrations, changes in the physical distance between component parts of the oscillator and the shield case and, therefore, changes in the oscillation frequency of the oscillator.

In one arrangement described below, a shield case for shielding parts constituting an electronic device and configured to prevent a stray capacitance between the parts and the shield case from changing comprises a first shield plate for shielding all of the parts of the electronic device, and a second shield plate affixed to a particular portion of the first shielding means, said particular portion causing a change in the stray capacitance which affects the frequency characteristics of the electronic device.

In a particular arrangement to be described of a shield case for shielding parts constituting an oscillator from other electronic devices, the shield case has a wall thickness which is greater in a particular portion causing a change in stray capacitance which affects the frequency characteristics of the oscillator.

A method to be described below, of producing a shield case for shielding parts constituting an oscillator from other electronic devices comprises the steps of producing a first shield plate for shielding all of the parts of the oscillator, producing a second shield plate to be affixed to a particular portion of the first shield plate, the particular portion causing a change in stray capacitance which affects the frequency characteristics of the oscillator, and affixing the second shield plate to the first shield plate.

The present invention consists of shield cases as defined in independent claims 1 and 6, and of methods of producing these shield cases as defined in independent claims 10 and 12.

Embodiments of the invention will now be described, by way of example, together with conventional arrangements, with reference to the accompanying drawings in which:

Fig. 1 is a section showing an oscillator having a conventional shield case;

Fig. 2 is a perspective view showing a specific construction of the conventional shield case;

Fig. 3 is a perspective view showing another specific construction of the conventional shield case;

Fig. 4A is a perspective view showing a shield case embodying the present invention;

Fig. 4B is a perspective view of a shield plate included in the embodiment;

Fig. 4C is a front view of the embodiment;

Fig. 4D is a plan view of the embodiment;

Fig. 4E is a side elevation of the embodiment;

Fig. 5A is a perspective view of a shield plate representative of an alternative embodiment of the present invention;

Fig. 5B is a front view of the alternative embodiment;

Fig. 5C is a plan of the alternative embodiment;

Fig. 5D is a side elevation of the alternative embodiment;

Fig. 5E is an arrangement of a mobile radio communication apparatus to which the alternative embodiment is applied;

Fig. 6 is a circuit diagram representative of an oscillator to which any of the embodiments of the present invention is applicable;

Fig. 7 is a block diagram schematically showing an arrangement usable to measure the S/N (Signal-to-Noise) ratios attainable with a conventional shield case and a shield case of the present invention against externally derived vibrations;

Fig. 8 is a graph showing S/N ratios particular to a conventional shield case having an even wall thickness; and

Fig. 9 is a graph showing S/N ratios obtained with an oscillator having a shield case in accordance with the present invention.

## DESCRIPTION OF THE PREFERRED EMBODIMENTS

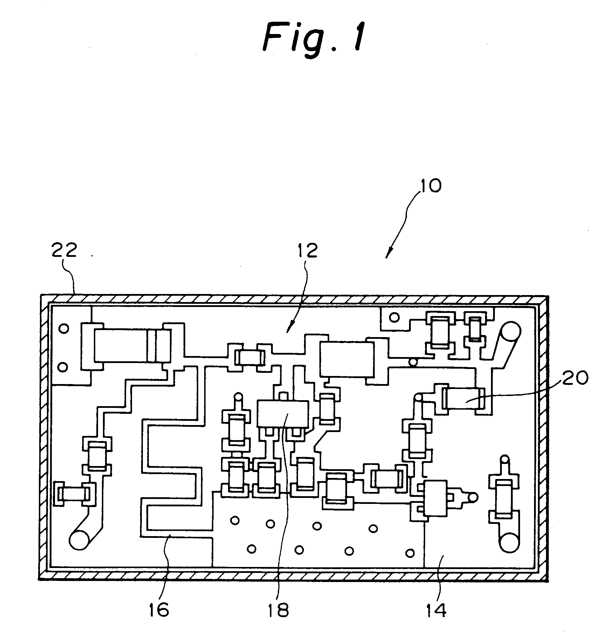

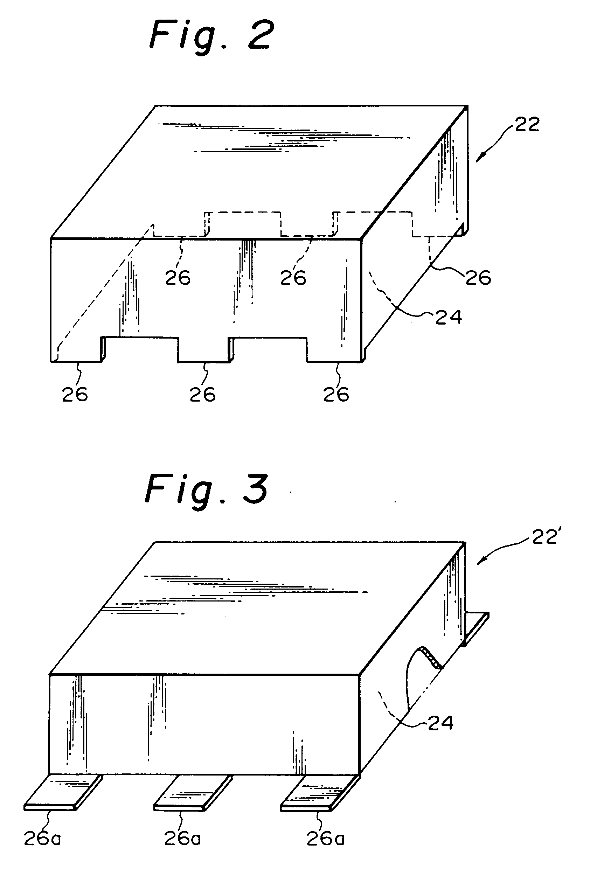

To better understand the present invention, a brief reference will be made to an oscillator with a conventional shield case, shown in Fig. 1. Specifically, Fig. 1 shows specific circuitry 12 provided on the body of a voltage controlled oscillator (VCO), for example, which is implemented with a conventional shield case. Provided on a hybrid substrate 14, the circuitry 12 has a strip line 16, various active elements 18, various passive elements 20, etc. The back (not visible) of the hybrid substrate 14 is connected to ground. Fig. 2 shows a specific construction of a conventional shield case 22. The shield case 22 covers the circuitry 12 of the substrate 14 to isolate it from the outside, as shown in Fig. 1. As Fig. 2 indicates, the shield case 22 has a box-like configuration having an opening 24 at the bottom thereof. A part 26 of the edges of the shield case 22 which define the opening 24 is soldered or otherwise connected to the back or grounding surface of the substrate 14. Assume that the face of the substrate 14, as distinguished from the back, is configured as a grounding surface. Then, use may be made of a modified shield case 22′ shown in Fig. 3. Specifically, the modified shield case 22′ has tongues 26a formed by bending a part of the edges of the opening 24 at right angle and soldered or otherwise connected to the edge portions of the face or grounding surface of the substrate 14.

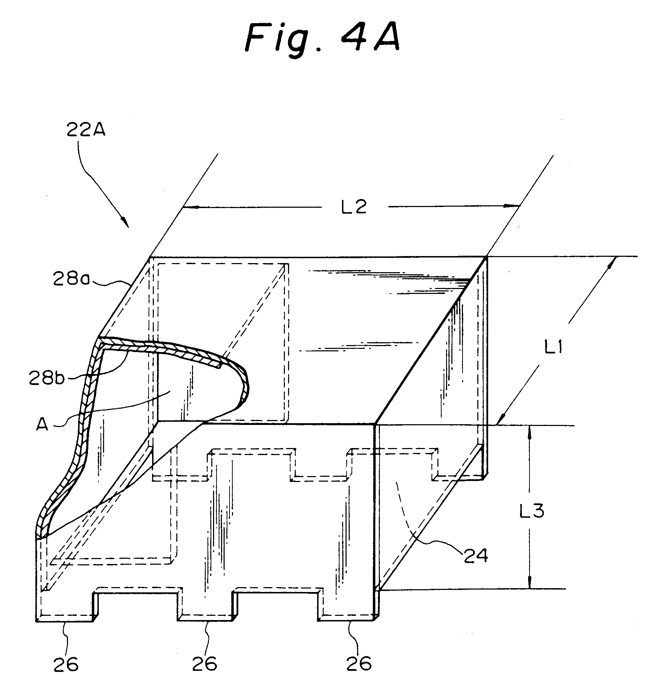

Figs. 4A to 4E show a shield case structure embodying the present invention and also applied to the VCO 10 depicted in Fig. 1. The shield case, generally 22A, covers the circuitry 12 of the VCO 10 from above to shield the strip line 16, active elements 18 and passive elements from the outside. The shield case 22A has an outer shield plate 28a implemented as a sheet of metal cut and bent in a desired configuration, and an inner shield plate 28b spot-welded or otherwise affixed to a part of the inner periphery of the outer shield plate 28a. Should the shield case 22A lack the inner shield plate 28b, vibrations applied from the outside to the shield case 22A would change the physical distance between the shield case 22A and the component parts of the circuitry 12 and thereby change the stray capacitance therebetween. As a result, the component parts arranged on the hybrid substrate 14 would exhibit unexpected characteristics to change the oscillation frequency of the VCO 10. Some of the component parts are especially susceptible to the changes in the stray capacitance. In the illustrative embodiment, the inner shield plate 28b affixed to a part of the inner periphery of the outer shield plate 28a provides double-protection against the above occurrence. Specifically, the space A defined by the inner shield plate 28b is occupied by the parts which are especially susceptible to the changes in the stray capacitance as mentioned above. Stated another way, the shield case 22A has a greater wall thickness in a portion thereof adjoining the space A than in the other portion. In this configuration, when vibration is imparted to the shield case 22A, the shield case 22A does not easily vibrate since it is thicker in the vicinity of the space A and, therefore, allows a minimum of change to occur in the physical distance between the parts accommodated in the space A and the shield case 22A. Hence, the oscillation frequency of the VCO 10 is prevented from noticeably changing. This advantage is attainable without any substantial increase in the overall weight or the heat capacity of the VCO 10.

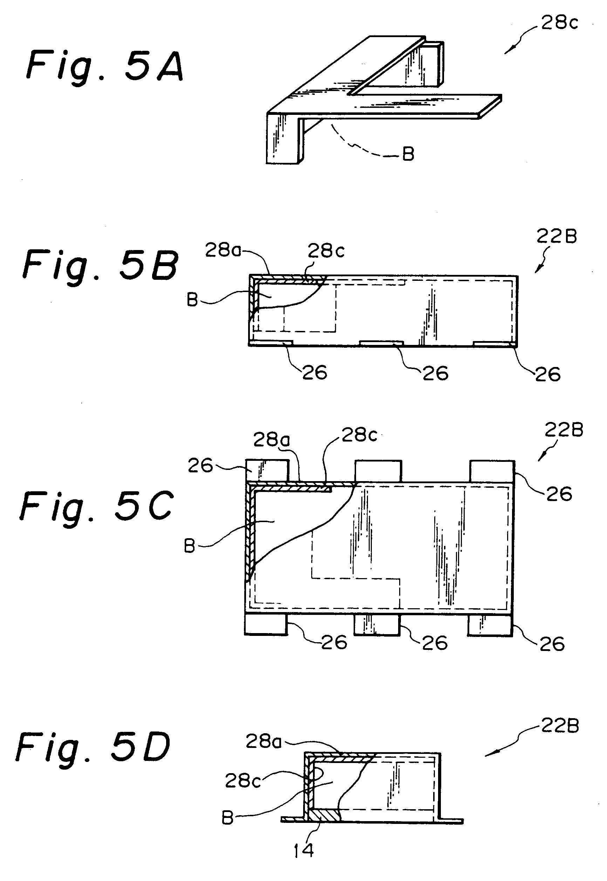

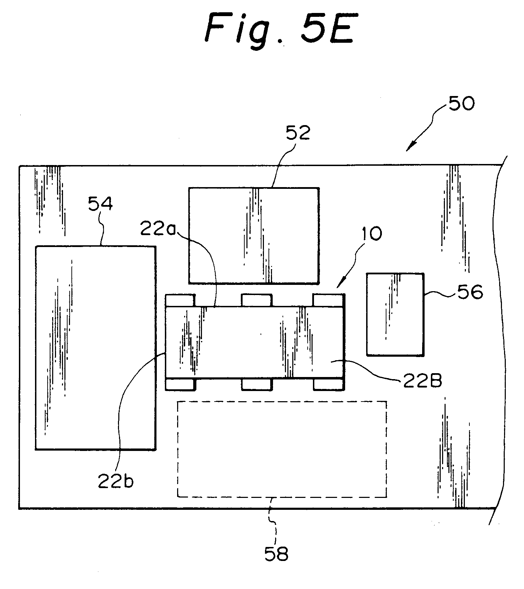

Figs. 5A to 5D show an alternative embodiment of the present invention. As shown, the shield case, generally 22B, has an inner shield plate 28c which is also spot-welded or otherwise affixed to a part of the inner periphery of the outer shield plate 28a and is different in configuration from the inner shield plate 28b. The inner shield plate 28c is affixed to a particular portion of the outer shield plate 28a which would, in the absence of the inner shield plate 28c, cause a change in the stray capacitance and affect the frequency characteristics of the VCO 10. The inner shield plate 28c having such a unique configuration is advantageously applicable to the shield case 22B of VCO 10 forming a part of a mobile radio communication apparatus which is arranged as shown in Fig. 5E by way of example. In Fig. 5E, a first and a second dielectric filter 52 and 54, a helical filter 56, and chips 58 are arranged around the VCO 10 in a particular positional relation. In this specific arrangement, the distance between the dielectric filter 52 and the wall 22a of the shield case 22B that faces the filter 52 is selected to be 3 millimeters, while the distance between the dielectric filter 54 and the wall 22b of the shield case 22B that faces the filter 54 is selected to be 1 millimeter. The alternative embodiment is comparable with the previous embodiment regarding the advantages over the prior art.

In any of the illustrative embodiments, the inner shield plate 28b or 28c is produced independently of the outer shield plate 28a and then affixed to the latter by spot-welding or similar technology. Alternatively, the shield plates 28a and 28b or 28c may be die-casted or otherwise fabricated integrally with each other so as to partly increase the wall thickness of the shield case as stated above.

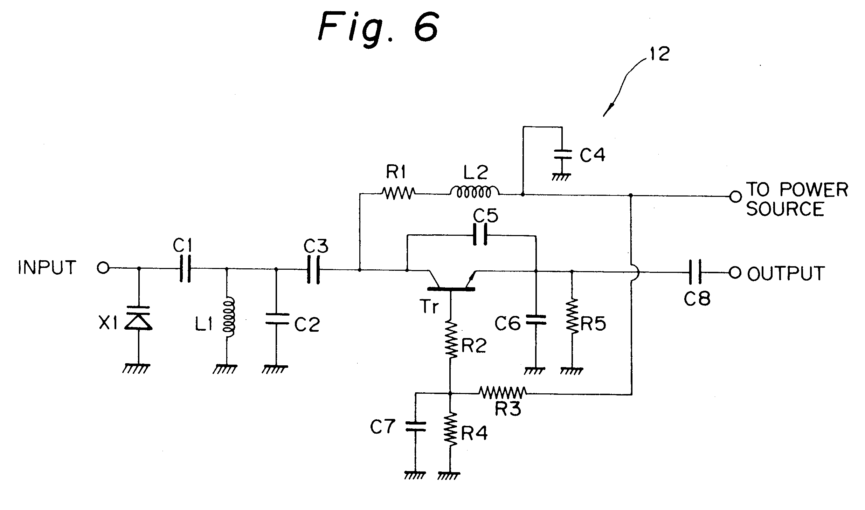

Fig. 6 shows a specific construction of the circuitry 12 provided on the body of the VCO 10 and which is implemented as a Colpitts oscillator by way of example. The oscillation frequency of the VCO 10 shown in Fig. 6 is determined by the capacitances of capacitors C5 and C6 and the composite inductance of various elements which are located closer to the input terminal than a capacitor C3. A varactor diode X1 changes its capacitance in response to a DC input voltage, while a capacitor C1 cuts DC components. An inductor L1 is implemented as a coil for oscillation and adjusts the oscillation frequency. The capacitor C3 cuts DC components applied to the collector of a transistor Tr. Assuming that the input is open, and that the impedance of the elements preceding the capacitor C3 is Z, then the impedance Z is expressed as:

$$Z = \frac{sL1\,(X1 + C1)}{s^2L1\,[X1 \cdot C1 + C2\,(X1 + C1)] + X1 + C1} + \frac{1}{sC3}$$

where $s$ is the Laplace operator.

Further, the impedance Z may be produced by:

$$Z = j\omega\,\hat{Z}(\omega)$$

where $\hat{Z}(\omega)$ is representative of a real function.

Therefore, it may be regarded that a coil having an inductance $\hat{Z}(\omega)$ exists between the input terminal and the capacitor C3. Resistors R1 and R2 free the transistor Tr from unusual oscillations, while an inductor L2 is a choke coil for preventing high frequency from leaking into the power source. Capacitors C4 and C7 release noise particular to the power source to ground. A capacitor C8 cuts DC components. Further, resistors R3 and R4 are bleeder resistors for determining the operating point of the transistor Tr, while a resistor R5 is an emitter resistor for determining the same.

Assuming that the oscillation frequency of the VCO 10 which is dependent on the capacitors C5 and C6 and inductor $\hat{Z}(\omega)$ is $f_o$, it is expressed as:

$$f_o = \frac{1}{2\pi}\sqrt{\frac{\frac{1}{C5} + \frac{1}{C6}}{\hat{Z}(\omega_o)}} \qquad (\omega_o = 2\pi f_o)$$

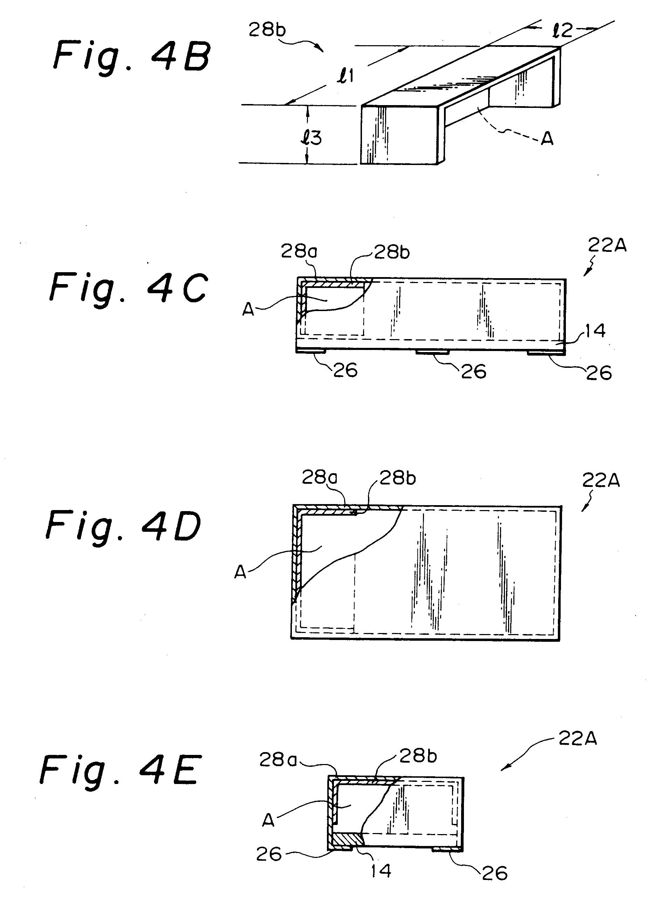

However, since the cicuitry 12 of the VCO 10 arranged as shown in Fig. 4 is covered with the shield case 22 (Fig. 2) or 22' (Fig. 3), stray capacitance is developed between the shield case 22 or 22' and the circuit parts and elements. Specifically, the oscillation frequency $f_o$ is affected by the stray capacitance developed from the collector of the transistor Tr to ground in parallel with the capacitors C2 and C6 and varactor diode X1. When the previously mentioned constants C2, X1, C6 and $\hat{Z}(\omega_o)$ are considered as variables, the degree to which the stray capacitance affects the oscillation frequency $f_o$ may be expressed by partial differentiation. However, which of such constants has the greatest influence is difficult to determine. In any case, it is obvious that the shield case caused to vibrate by the externally derived vibration changes the stray capacitance and, as a result, the oscillation frequency is changed as if it were frequency modulated with the vibrations. The shield case 22A or 22B in accordance with the present invention absorbs external vibrations and, therefore, does not vibrate since it has a greater wall thickness in a portion thereof adjoining the space A or B than in the other portion. This is successful in preventing the oscillation frequency from being changed by the change in stray capacitance.

An oscillator with a conventional shield case which is made of phosphor bronze or similar metal and implemented only with the shield plate having an even wall thickness as shown in Fig. 1 or 2 and an oscillator with a shield case of the present invention which is made up of an outer and an inner shield plate were compared with respect to the S/N ratio, as follows.

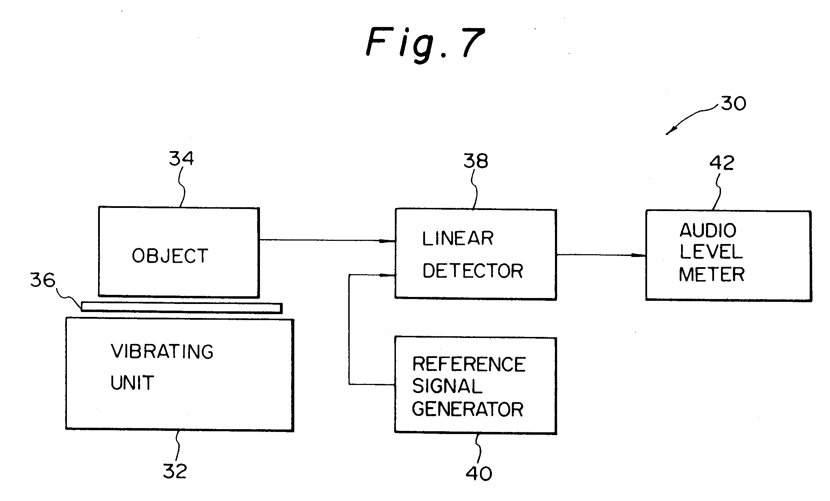

As shown in Fig. 7, an arrangement used for measurement, generally 30, has a vibrating unit 32 which is loaded with an object 34 with the intermediary of a 30 millimeters thick baked plate 36. The vibrating unit 32 vibrates the object 34, i. e., the conventional oscillator or the oscillator implemented with the present invention by way of the baked plate 36. The object 34 is affixed to the baked plate 36 at three points, while the baked plate 36 is affixed to the vibrating unit 32 at six points. For measurement, the vibrating unit 32 caused the object 34 to vibrate by 0. 24 millimeter (peak-to-peak) at 10 to 50 hertz and by the gravitational accelaration of 1.53 over 50 hertz. The arrangement 30 further has a linear detector 38 to which the outputs of the object 34 and a reference signal generator 40 are applied, and an audio level meter 42 to which the output of the linear detector 38 is applied. The reference signal generator 40 generates an FM signal of 1 kilohertz with 3 kilohertz deviation. The linear detector 38 has no frequency band limitation and the audio level meter 42 includes a psophometric filter therein.

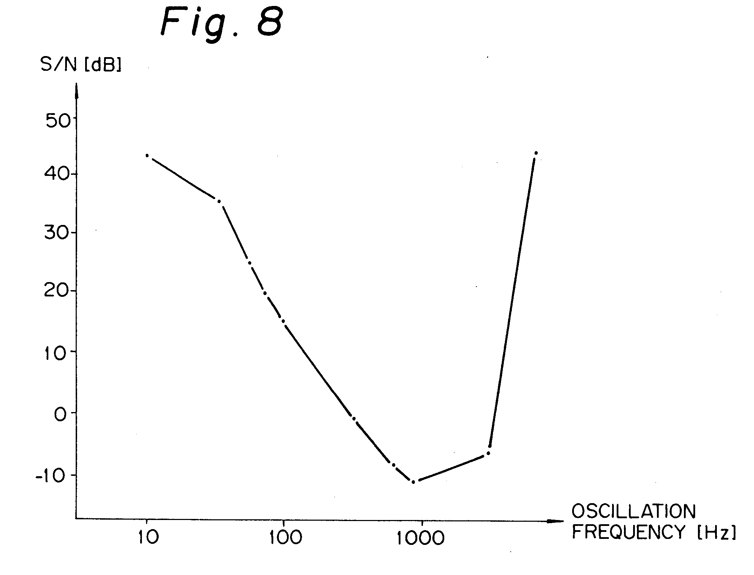

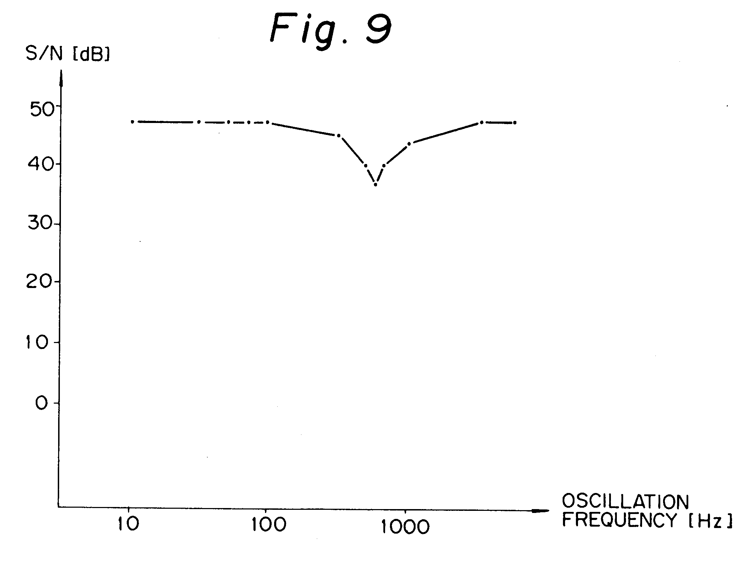

Assume that the audio level determined by the linear detector 38 by demodulating the output of the object 34 under vibration is N, and that the audio level determined by the detector 38 by demodulating the output of the reference signal generator 40 is S. First, the S/N ratio was determined with the conventional shield case by the arrangement 30. Specifically, a 0. 3 millimeter thick conventional shield case 22 or 22' made of phosphor bronze was used. Fig. 8 indicates the S/N ratio (dB) to vibration frequency (Hz) characteristic particular to the oscillator with the 0. 3 millimeter thick shield case, as determined by the measurement. By contrast, Fig. 9 shows a S/N radio (dB) to vibration frequency (Hz) characteristic obtained with the oscillator with the shield case 22A of the present invention. For the measurement, the shield case 22A was provided with a 0. 3 millimeter thick outer shield plate 28a made of phosphor bronze and a 0. 8 millimeter thick inner shield plate 28b also made of phosphor bronze. As shown in Fig. 4A, the outer shield plate 28a had a length L1 of 11. 9 millimeters, a width L2 of 26. 0 millimeters, and a height L3 of 4. 7 millimeters. On the other hand, as shown in Fig. 4B, the inner shield plate 28b has a length $l1$ of 11. 2 millimeters, a width $l2$ of 17. 7 millimeters, and a height $l3$ of 3. 0 millimeters.

The minimum S/N ratio of the conventional shield case 22 or 22' shown in Fig. 8 is smaller than zero decibel (about -12 decibels). On the other hand, the minimum S/N ratio particular to the present invention is about 37 decibels as shown in Fig. 9, which is a remarkable improvement over the prior art, i. e. by about 50 decibels.

In summary, it will be seen that the present invention provides a shield case structure which is partly increased in wall thickness and, therefore, not susceptible to external vibrations. This prevents the physical distance between the shield case and circuitry provided on the body of an oscillator from changing. As a result, the oscillator with such a shield case is capable of oscillating stably in spite of vibrations which may be applied from the outside. Such a shield case structure is achievable without increasing the overall weight or the heat capacity of the oscillator.

Although particular arrangements have been described in illustrating the invention, it will be understood that variations and modifications thereof, as well as other embodiments, may be made within the scope of the appended claims.

## Claims

1. A shield case (22A) for shielding parts (12) of an electronic device (10) and configured to prevent stray capacitance between the parts (12) and the shield case (22A) from changing as a result of externally derived vibrations, the shield case (22A) including first shielding means (28a) for shielding all of the parts of the electronic device (10) and second shielding means (28b) affixed to a particular portion of the first shielding means (28a), the particular portion being a portion which would cause in the absence of the second shielding means, a change in the stray capacitance which would affect the frequency characteristics of the electronic device (10).

2. A shield case (22A) as claimed in claim 1, in which the first (28a) and the second (28b) shielding means is respectively an outer shield plate (28a) and an inner shield plate (28b).

3. A shield case (22A) as claimed in claim 2, in which the inner shield plate (28b) has been affixed to the outer shield plate (28a) by spot-welding.

4. A shield case (22A) as claimed in claim 1, in which the first (28a) and the second (28b) shielding means have been produced integrally by die-casting.

5. A shield case (22A) as claimed in claim 1, in which the electronic device (10) is an oscillator.

6. A shield case (22A) for shielding parts (12) of an oscillator from other electronic devices, in which the wall thickness of the shield case (22a) is greater in a particular portion than in another, which particular portion would, as a result of externally derived vibration and in the absence of the greater wall thickness, cause a change in the stray capacitance between the parts (12) and the shield case (22a) and affect the frequency characteristics of the oscillator.

7. A shield case (22A) as claimed in claim 6, in which the shield case (22A) includes a first shield plate (28a) shielding all of the parts of the oscillator, and a second shield plate (28b) affixed to the first shield plate (28a) in the vicinity of particular parts (52) (54) (56) (58) for shielding only the particular parts (52) (54) (56) (58).

8. A shield case (22A) as claimed in claim 7, in which the second shield plate (28b) has been affixed to the first shield plate (28a) by spot-welding.

9. A shield case (22A) as claimed in claim 6, in which the shield case (22A) has been produced by die-casting.

10. A method of producing the shield case (22A) as claimed in either claim 1 or claim 6 for shielding parts of an oscillator from other electronic devices, including the steps of (a) producing a first shield plate (28a) for shielding all of the parts of the oscillator, (b) producing a second shield plate (28b) to be affixed to the particular portion of the first shield plate (28a), the particular portion being that portion which would cause a change in the stray capacitance affecting the frequency characteristics of the oscillator in the absence of the second shield plate (28b), and (c) affixing the second shield plate (28b) to the first shield plate (28a).

11. A method as claimed in claim 10, in which the second shield plate (28b) is affixed to the first shield plate (28a) in step (c) by spot-welding.

12. A method of producing the shield case (22A) as claimed in either claim 1 or claim 6, in which the shield case is produced by die-casting.

## Patentansprüche

1. Abschirmgehäuse (22A) zum Abschirmen von Teilen (12) einer elektronischen Vorrichtung (10) und so konfiguriert, daß es eine Änderung einer Streukapazität zwischen den Teilen (12) und dem Abschirmgehäuse (22A) als Ergebnis von äußerlich zugeführten Vibrationen verhindert, wobei das Abschirmgehäuse (22A) aufweist: eine erste Abschirmeinrichtung (28a) zum Abschirmen aller Teile der elektronischen Vorrichtung (10) und eine zweite Abschirmeinrichtung (28b), die an einem besonderen Abschnitt der ersten Abschirmeinrichtung (28a) befestigt ist, wobei der besondere Abschnitt ein Abschnitt ist, der bei Fehlen der zweiten Abschirmeinrichtung eine Änderung der Streukapazität verursachen würde, was die Frequenzcharakteristik der elektronischen Vorrichtung (10) beeinträchtigen würde.

2. Abschirmgehäuse (22A) nach Anspruch 1, wobei die erste (28a) und die zweite Abschirmeinrichtung (28b) eine äußere Abschirmplatte (28a) bzw. eine innere Abschirmplatte (28b) ist.

3. Abschirmgehäuse (22A) nach Anspruch 2, wobei die innere Abschirmplatte (28b) an der äußeren Abschirmplatte (28a) durch Punktschweißen befestigt wurde.

4. Abschirmgehäuse (22A) nach Anspruch 1, wobei die erste (28a) und die zweite Abschirmeinrichtung (28b) in einem Stück durch Druckgießen hergestellt wurden.

5. Abschirmgehäuse (22A) nach Anspruch 1, wobei die elektronische Vorrichtung (10) ein Oszillator ist.

6. Abschirmgehäuse (22A) zum Abschirmen von Teilen (12) eines Oszillators gegenüber anderen elektronischen Vorrichtungen, wobei die Wanddicke des Abschirmgehäuses (22A) in einem besonderen Abschnitt größer als in einem anderen ist, wobei der besondere Abschnitt als Ergebnis einer äußerlich zugeführten Vibration und bei Fehlen der größeren Wanddicke eine Änderung der Streukapazität zwischen den Teilen (12) und dem Abschirmgehäuse (22A) verursachen und die Frequenzcharakteristik des Oszillators beeinträchtigen würde.

7. Abschirmgehäuse (22A) nach Anspruch 6, wobei das Abschirmgehäuse (22A) aufweist: eine erste Abschirmplatte (28a), die alle Teile des Oszillators abschirmt, und eine an der ersten Abschirmplatte (28a) in der Nähe von besonderen Teilen (52, 54, 56, 58) befestigte zweite Abschirmplatte (28b) zum alleinigen Abschirmen der besonderen Teile (52, 54, 56, 58).

8. Abschirmgehäuse (22A) nach Anspruch 7, wobei die zweite Abschirmplatte (28b) an der ersten Abschirmplatte (28a) durch Punktschweißen befestigt wurde.

9. Abschirmgehäuse (22A) nach Anspruch 6, wobei das Abschirmgehäuse (22A) durch Druckgießen hergestellt wurde.

10. Verfahren zum Herstellen des Abschirmgehäuses (22A) nach Anspruch 1 oder Anspruch 6 zum Abschirmen von Teilen eines Oszillators gegenüber anderen elektronischen Vorrichtungen mit den folgenden Schritten: (a) Herstellen einer ersten Abschirmplatte (28a) zum Abschirmen aller Teile des Oszillators, (b) Herstellen einer zweiten Abschirmplatte (28b), die an dem besonderen Abschnitt der ersten Abschirmplatte (28a) zu befestigen ist, wobei der besondere Abschnitt jener Abschnitt ist, der bei Fehlen der zweiten Abschirmplatte (28b) eine die Frequenzcharakteristik des Oszillators beeinträchtigende Änderung der Streukapazität verursachen würde, und (c) Befestigen der zweiten Abschirmplatte (28b) an der ersten Abschirmplatte (28a).

11. Verfahren nach Anspruch 10, wobei die zweite Abschirmplatte (28b) an der ersten Abschirmplatte (28a) im Schritt (c) durch Punktschweißen befestigt wird.

12. Verfahren zum Herstellen des Abschirmgehäuses (22A) nach Anspruch 1 oder Anspruch 6, wobei das Abschirmgehäuse durch Druckgießen hergestellt wird.

## Revendications

1. Boîtier de blindage (22A) pour blinder des parties (12) d'un dispositif électronique (10) et configuré afin d'empêcher la capacité parasite entre les parties (12) et le boîtier de blindage (22A) de changer du fait de vibrations obtenues de manière externe, le boîtier de blindage (22A) comprenant un premier moyen de blindage (28a) pour blinder toutes les parties du dispositif électronique (10) et un second moyen de blindage (28b) fixé à une partie particulière du premier moyen de blindage (28a), la partie particulière étant une partie qui entraînerait en l'absence du second moyen de blindage, un changement de capacité parasite qui affecterait les caractéristiques en fréquence du dispositif électronique (10).

2. Boîtier de blindage (22A) selon la revendication 1, dans lequel le premier (28a) et le second (28b) moyen de blindage sont respectivement une plaque de blindage extérieure (28a) et une plaque de blindage d'intérieur (28b).

3. Boîtier de blindage (22A) selon la revendication 2, dans lequel la plaque de blindage intérieur (28b) a été fixée à la plaque de blindage extérieure (28a) par soudure par point.

4. Boîtier de blindage (22A) selon la revendication 1, dans lequel le premier (28a) et le second (28b) moyen de blindage ont été produits intégralement par moulage par pression.

5. Boîtier de blindage (22A) selon la revendication 1, dans lequel le dispositif électronique (10) est un oscillateur.

6. Boîtier de blindage (22A) pour blinder des parties (12) d'un oscillateur par rapport à un autre dispositif électronique, dans lequel l'épaisseur de paroi du boîtier de blindage (22a) est supérieure dans une partie particulière plutôt que dans une autre, laquelle partie particulière, comme un résultat de la vibration obtenue de manière externe et en l'absence de l'épaisseur de paroi supérieure, entraînerait un changement de la capacité parasite entre les parties (12) et le boîtier de blindage (22a) et affecterait les caractéristiques en fréquence de l'oscillateur.

7. Boîtier de blindage (22A) selon la revendication 6, dans lequel le boîtier de blindage (22A) comprend une première plaque de blindage (28a) blindant toutes les parties de l'oscillateur et une seconde plaque de blindage (28b) fixée à la première plaque de blindage (28a) au voisinage de parties particulières (52) (54) (56) (58) pour blinder seulement les parties particulières (52) (54) (56) (58).

8. Boîtier de blindage (22A) selon la revendication 7, dans lequel la seconde plaque de blindage (28b) a été fixée à la première plaque de blindage (28a) par soudage par point.

9. Boîtier de blindage (22A) selon la revendication 6, dans lequel le boîtier de blindage (22A) a été produit par moulage par pression.

10. Procédé de production du boîtier de blindage (22A) selon la revendication 1 ou la revendication 6, pour blinder des parties d'un oscillateur par rapport à d'autres dispositifs électroniques, comprenant les étapes consistant à (a) produire une première plaque de blindage (28a) pour blinder toutes les parties de l'oscillateur, (b) produire une seconde plaque de blindage (28b) qui doit être fixée à la partie particulière de la première plaque de blindage (28a), la partie particulière étant cette partie qui entraînerait un changement de la capacité parasite affectant les caractéristiques en fréquence de l'oscillateur en l'absence de la seconde plaque de blindage (28b) et (c) fixer la seconde plaque de blindage (28b) à la première plaque de blindage (28a).

11. Procédé selon la revendication 10, dans lequel la seconde plaque de blindage (28b) est fixée à la première plaque de blindage (28a) à l'étape (c) par soudage par point.

12. Procédé de production du boîtier de blindage (22A) selon la revendication 1 ou la revendication 6, dans lequel le boîtier de blindage est produit par moulage par pression.

# Fig. 1

*Fig. 2*

*Fig. 3*

# Fig. 4A

*Fig. 4B*

28b

ℓ2

ℓ1

ℓ3

A

*Fig. 4C*

28a    28b

22A

A

14

26    26    26

*Fig. 4D*

28a    28b

22A

A

*Fig. 4E*

28a    28b

22A

A

26

14

26

*Fig. 5A*

28c

B

*Fig. 5B*

28a    28c    22B

B

26    26    26

*Fig. 5C*

26    28a    28c    22B

B    26

26    26    26

*Fig. 5D*

22B

28a

28c

B

14

# Fig. 5E

# Fig. 6

EP 0 437 313 B1

Fig. 7

30

34 OBJECT

36

32 VIBRATING UNIT

38 LINEAR DETECTOR

40 REFERENCE SIGNAL GENERATOR

42 AUDIO LEVEL METER

# Fig. 8

S/N [dB]

50

40

30

20

10

0

-10

10    100    1000

OSCILLATION
FREQUENCY [Hz]

Fig. 9